# EUROPÄISCHE PATENTSCHRIFT

(11) **EP 0 835 497 B1**
(45) Veröffentlichungstag und Bekanntmachung des Hinweises auf die Patenterteilung: **27.03.2013**
(21) Anmeldenummer: 96918600.6
(22) Anmeldetag: 24.06.1996
(51) Int. Cl.: G06K 19/077

(54) **CHIPKARTE**
Chip card
CARTE A PUCE

(30) Priorität: 27.06.1995 DE 19523242; 01.09.1995 DE 19532223
(43) Veröffentlichungstag der Anmeldung: 15.04.1998
(73) Patentinhaber: Morpho Cards GmbH, 24220 Flintbek (DE)
(72) Erfinder: TRÜGGELMANN, Uwe, D-33098 Paderborn (DE); WENDISCH, Karlheinz, D-33154 Salzkotten (DE)
(74) Vertreter: Richardt Patentanwälte GbR
(86) Internationale Anmeldenummer: PCT/DE1996/001105
(87) Internationale Veröffentlichungsnummer: WO 1997/001823

(56) Entgegenhaltungen:
- EP-A- 0 412 316
- WO-A-94/02912
- DE-A- 4 328 469
- FR-A- 2 695 234
- US-A- 4 725 111
- DETNER UND ELZE: "Handbuch der Galvanotechnik, Band III" 1969 , CARL HANSER VERLAG , MÜNCHEN XP002022073 in der Anmeldung erwähnt siehe Seite 291 - Seite 292

## Beschreibung

Die Erfindung bezieht sich auf ein Verfahren zur Herstellung von Chipmodulen für kontaktbehaftete Chipkarten, die ein solches Chipmodul (Trägerelement für den IC-Baustein/Chip) mit elektrisch leitfähigen Kontaktflächen aufweisen. Diese Kontaktflächen sind mit entsprechenden Anschlußpunkten des IC-Bausteines elektrisch leitend verbunden, so daß hierüber die Kommunikation des IC-Bausteines mit entsprechenden Geräten (Chipkartenterminals/Automaten) ermöglicht wird. Das Chipmodul wird in einer zur Kartenvorderseite hin offenen Aussparung des Kartenkörpers fixiert. Die Oberfläche des Chipmoduls ist dabei von einer strukturierten, die elektrisch leitfähigen Kontaktflächen bildenden Metallisierung mit isolierenden Zwischenräumen (Linien) gebildet. Die Kontaktflächen sind in der Ebene der Kartenvorderseite oder minimal (ca.± 0,1mm) gegenüber dieser versetztstehend angeordnet.

Derartige Chipkarten haben bereits eine große Verbreitung gefunden in Form von Telefonkarten, Krankenversichertenkarten, GSM-Karten, Bank-und Kreditkarten.

Das Layout dieser Karten (Kartenvorderseite und Rückseite) ist in aufwendiger Weise gestaltet. Dabei wirkt die sichtbare Oberfläche des Chipmoduls mit seinen Kontaktflächen als Fremdkörper im Layout der Kartenvorderseite, wodurch das optische Erscheinungsbild nachteilig beeinflußt ist und die Layout-Gestaltungsmöglichtkeiten beeinträchtigt sind. Die Kontaktflächen weisen entweder eine Metallisierung aus Gold, Silber oder Palladium auf, wobei die Palladium-Metallisierung silberfarben erscheint. Diese Metalle sind zur Bildung von Kontaktoberflächen besonders gut geeignet, da sie zum einen chemisch sehr inert sind, d.h. insbesondere nicht oxidieren oder korrodieren, und mit ihnen zum anderen sehr niedrige Übergangswiderstände zu den Kontakten des Chipkartenterminals erzielbar sind. Außerdem besitzen Gold und Palladium, insbesondere mit speziellen Legierungszusätzen, eine hohe Verschleißfestigkeit. Aus diesen Gründen wird heute für die Kontaktflächen von Chipkarten fast ausschließlich Gold oder Palladium verwendet. Somit besteht für die Layout-Gestaltung nur die Wahl zwischen einem Chipmodul mit gold- oder silberfarbener Oberfläche.

Aus der WO 94/02 912 ist ein auf einer Speicherkarte angeordnetes Kontaktfeld bekannt, das mit einem integrierten, elektrisch leitfähigem Darstellungs-Symbol, zum Beispiel in Form eines Posthorns versehen ist. Dadurch soll die Fälschungssicherheit der Speicherkarte verbessert werden, da ein Kartenfälscher nicht ohne Weiteres in der Lage ist, das Darstellungs-Symbol im Kontaktfeld unterzubringen. Die Unterbringung des Schriftzeichens oder Darstellungs-Symbols im Kontaktfeld erfolgt mit einer entsprechenden Maske.

Aus der DE 43 28 469 A1 ist eine IC-Karte mit integriertem Baustein bekannt. Eine farbig ausgebildete Klebeschicht dient hier zur Fixierung eines Chipmoduls.

Aus der FR 26 95 234 A1 ist ein weiteres Markierungsverfahren für die Kontakte einer Chipkarte bekannt.

Aufgabe der Erfindung ist es daher, ein weiteres Verfahren zur Herstellung von Chipmodulen für Chipkarten zu schaffen, bei der die Oberfläche des Chipmoduls an die" Layout-Gestaltung der Kartenvorderseite angepaßt werden kann, d.h. als gestalterische Oberfläche miteinbezogen werden kann, so daß die Gestaltungsmöglichkeiten für das optische Erscheinungsbild der Chipkarte erweitert werden.

Da es sich bei Chipkarten um sensible Datenträger und geldwerte Speichermedien handelt ist bei der Lösung dieser Aufgabe besonders darauf zu achten, daß die technische Zuverlässigkeit nicht beeinträchtigt wird. Da es sich darüber hinaus bei Chipkarten um einen in großen Stückzahlen hergestellten Massenartikel handelt, ist eine kostengünstige Lösung ebenfalls besonders wichtig.

Diese Aufgabe wird durch die Merkmale des Patentanspruchs 1 gelöst. Der Unteranspruch enthält eine vorteilhafte Ausgestaltung der Erfindung.

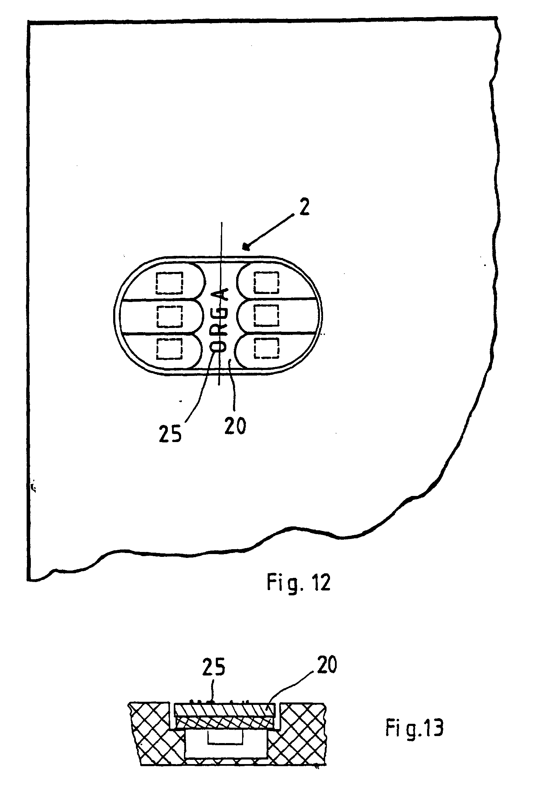

An Hand der beigefügten Zeichnungen soll die Erfindung nachfolgend näher erläutet werden, wobei die in den Figuren 12 bis 14 dargestellten Gegenstände nicht zu der beanspruchten Erfindung gehören, sondern nur zur Erleichterung des Verständnisses der Erfindung dienen:

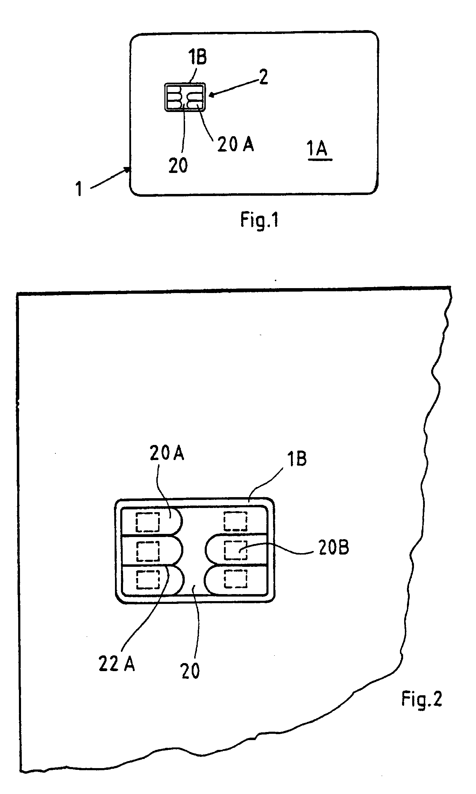

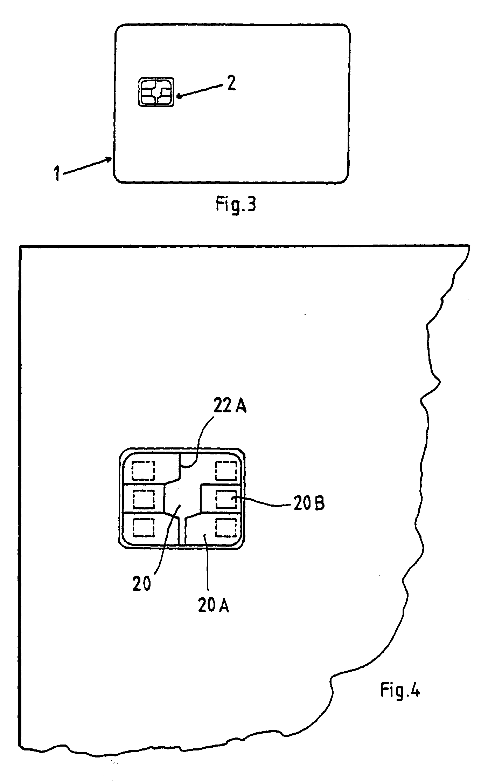

Fig. 1 zeigt eine Draufsicht auf die Vorderseite einer Standardchipkarte (1) mit dem darin eingebetteten Chipmodul (2) und dessen elektrischen Kontaktflächen (20A). In Figur 2 ist ein vergrößerter Ausschnitt der Karte (1) in Figur 1 im Bereich des Chipmoduls (2) dargestellt. Die Oberfläche des Chipmoduls (2) wird von einer strukturierten, die elektrisch leitfähigen Kontaktflächen (20A) bildenden Metallisierung (20) mit isolierenden Zwischenräumen (Linien, 22A) gebildet. Figur 3 und 4 zeigen das entsprechende jedoch mit einer anderen Strukturierung der Kontaktflächen (20A).

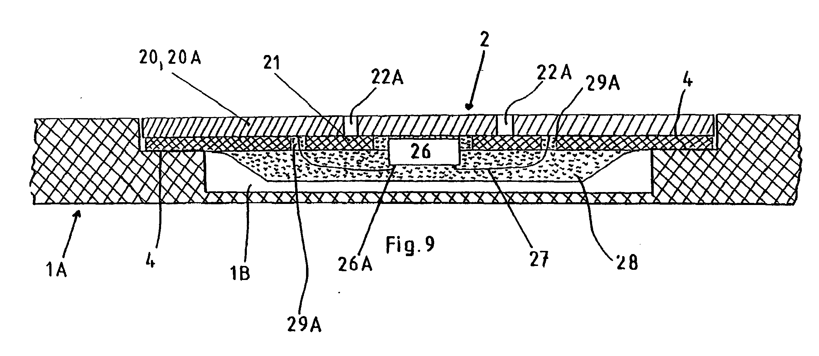

Die Metallisierung (20), die auf einem nicht leitenden Kunststoff-Substrat (21) aufgebracht ist (vgl.Fig. 9), wird typischerweise von einer auf dem Kunstoff-Substrat (21) aufkaschierten Kupferschicht, einer darauf galvanisch abgeschiedenen Nickelschicht und einer darauf wiederum abgeschiedenen Gold oder Palladiumschicht gebildet. Die Kupferschicht hat typischerweise eine Dicke von 35µm, die Nickelschicht eine Dicke von 15µm und die Gold- oder Palladiumschicht eine Dicke von 2µm.

Zwischenprodukt zur Herstellung von Chipmodulen (2) ist ein Kunststoff-Substratband, auf dem eine Vielzahl von Kontaktflächen-Einheiten aufgebracht ist.

Gemäß einer Lösungsvariante, die nicht zu der beanspruchten Erfindung gehört, und die hier nur zur Erleichterung des Verständnisses der Erfindung angegeben wird, wird die Farbe der Kontaktflächen (20A) gezielt eingestellt, indem dieses Zwischenprodukt in ein Färbebad (Färbelösung) eingebracht wird. Die Farbe der Kontaktflächen (20A) wird dabei durch eine chemische Reaktion an der Oberfläche und/oder im oberflächennahen Bereich der Metallisierung (20) (Reaktionsschichtdicke < 1µm) bewirkt. Dies kann in einem reinen Tauchverfahren, d.h. ohne Verwendung einer äußeren Stromquelle, oder in einem elektrolytischen/galvanischen Verfahren, d.h. unter Verwendung einer äußeren Stromquelle realisiert werden.

Zur Grünfärbung einer Goldkontaktoberfläche kann z.B. folgende Färbelösung verwendet werden: (siehe zum Beispiel: Handbuch der Galvanotechnik, Carl Hanser Verlag, München 1969, Band III, Seiten 291,292)

| | |
|---|---|
| Kaliumnitrat (30 Gew.%) | **KNO₃** |
| Eisen(II)-sulfat (10 Gew.%) | **FeSO₄*7H₂O** |
| Zinksulfat (5 Gew. %) | **ZnS0₄*7H₂O** |
| Kaliumaluminiumsulfat (5 Gew.%) | **KAl (S0₄) ₂*12H₂O** |
| Wasser (50 Gew.%) | **H₂O** |

Färbeparameter wie Temperatur, Färbedauer, Rührung(Konvektion) sind jeweils den spezifischen Bedingungen optimal anzupassen; durch Verwendung jeweils spezieller Färbelösungen kann somit insgesamt ein breites Farbspektrum abgedeckt werden.

Eine Einfärbung ist nicht beschränkt auf Gold-, Palladium- oder Silberkontaktflächen. Ebenso lassen sich andere Metallisierungen (20) verfärben und als äußere Kontaktflächenschicht verwenden.

Durch die Färbung werden funktionelle Eigenschaften, wie chemische Beständigkeit, Leitfähigkeit, Abriebfestigkeit und Lichtbeständigtkeit nicht nachteilig beeinflußt.

Durch selektive Abdeckung (Passivierung) der Metallisierung (20) durch Fotoresist vor dem Einbringen in eine Färbelösung ist es möglich, verschieden farbige Kontaktflächen (20A) herzustellen, was natürlich auch verschiedene Farben auf einer Kontaktfläche beinhaltet. Zur Veranschaulichung seien beispielhaft die Verfahrensschritte zur Herstellung eines zweifarbigen Streifenmusters kurz erläutert:

1. vollflächiges Aufbringen von Fotoresist, 2. Belichten mit der Streifenmustermaske für die erste Farbe, 3. Entfernen des nicht fixierten Fotoresist, 4. Einbringen in das erste Färbebad, 5. Nachbehandlung des ersten Färbevorganges, 6. vollflächiges Aufbringen von Fotoresist, 7. Belichten mit der zur ersten Maske komplementären Streifenmustermaske für die zweite Farbe, 8. Entfernen des nicht fixierten Fotoresist, 9. Einbringen in die zweite Färbelösung, 10. Nachbehandlung des zweiten Färbevorganges. Mit demselben Verfahren lassen sich dann natürlich in weiteren Schritten drei oder mehrere Farben aufbringen.

Durch unlösliche Zusätze in der Färbelösung kann eine velourartige Beschaffenheit der Metallisierung (20) erreicht werden.

Es sei noch angemerkt, daß die vorstehend beschriebene Lösungsvariante auch bei Kontaktflächen (20A) in der sogenannten Lead-frame-Technik anzuwenden ist. Hierbei ist die die Kontaktflächen (20A) bildende Metallisierung (20) nicht auf einem Kunststoff-Substrat aufgebracht.

Erfingungsgemäß ist es dagegen vorgesehen, daß die Metallisierung des Chipmoduls mindestens zwei Flächenbereiche aufweist, deren sichtbare Schicht aus verschiedenen Metallen und/oder Metallegierungen mit jeweils unterschiedlichen Lichtreflexions- und absorptionseigenschaften gebildet ist. Bei der Herstellung von Chipmodulen für solche Chipkarten wird wie folgt verfahren: Ein zur Herstellung von Chipmodulen (2) dienendes Kunststoff-Substrat, auf dem für eine Vielzahl von Chipmodulen eine Basismetallisierung (201,202) aufgebracht ist, wird in ein galvanisches Bad eingebracht, wo die verschiedenen Flächenbereiche (20*,20**) jeweils durch galvanische Abscheidung mit Hilfe selektiver Abdeckung (Passivierung) gebildet werden.

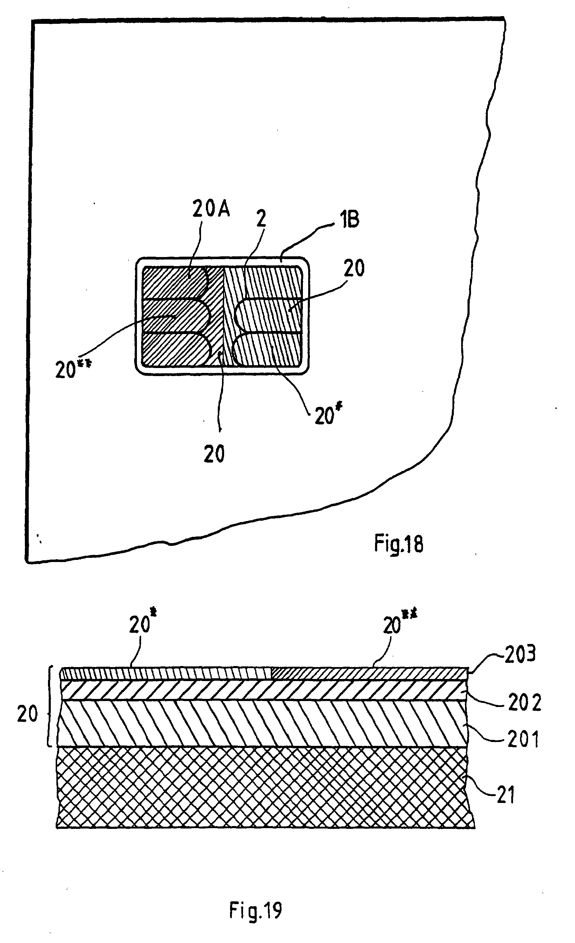

In Figur 18 ist ein vergrößerter Ausschnitt der Karte (1) im Bereich des Chipmoduls (2) dargestellt. Die Oberfläche des Chipmoduls ist von einer struktuierten, die elektrisch leitfähigen Kontaktflächen (20A) bildenden Metallisierung (20) gebildet. Die Metallisierung weist dabei zwei Flächenbereiche aus unterschiedlichen Metallen und/oder Metallegierungen mit verschiedenen Lichtreflexions- und absorptionseigenschaften auf. In Figur 19 ist ein Schichtaufbau der Metallisierung (20) dargestellt. Auf einem nichtleitenden Kunststoff-Substrat (22) mit einer aufkaschierten Kupferschicht (201) wird als Diffusionsbarriere eine Schicht (202), z.B. eine Nickelschicht, galvanisch abgeschieden. Mit Hilfe selektiver Abdeckung (Passivierung) durch Fotoresist ist es möglich, auf verschiedenen Flächenbereichen (20*,20**) der Nickelschicht (202) unterschiedliche Metalle und/oder Metallegierungen aufzubringen. Die Basismetallisierung kann auch von drei Schichten (z.B. Kupfer, Nickel und Gold) gebildet sein.

In einer ersten Ausgestaltungsform (s. Fig.19) liegen die verschieden farbigen Flächenbereiche in einer Ebene.

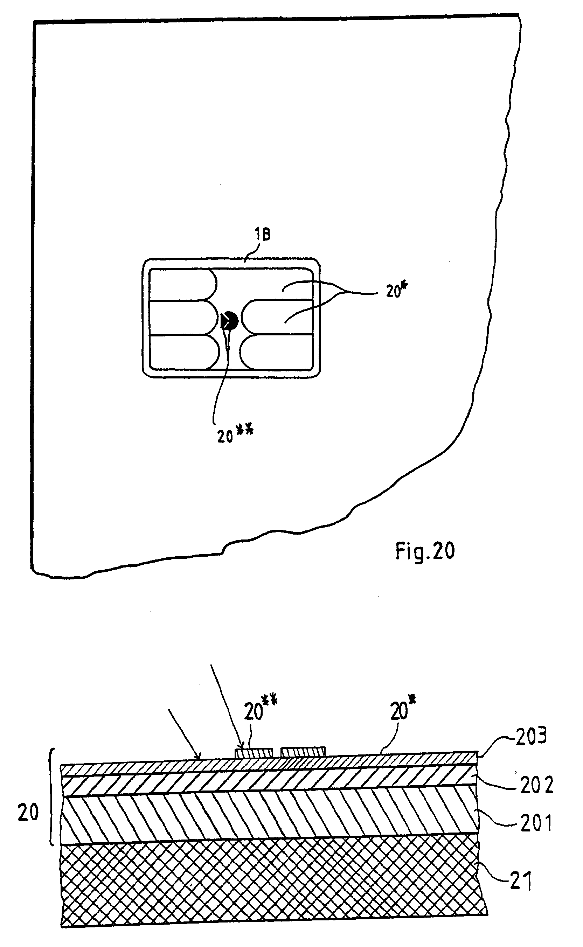

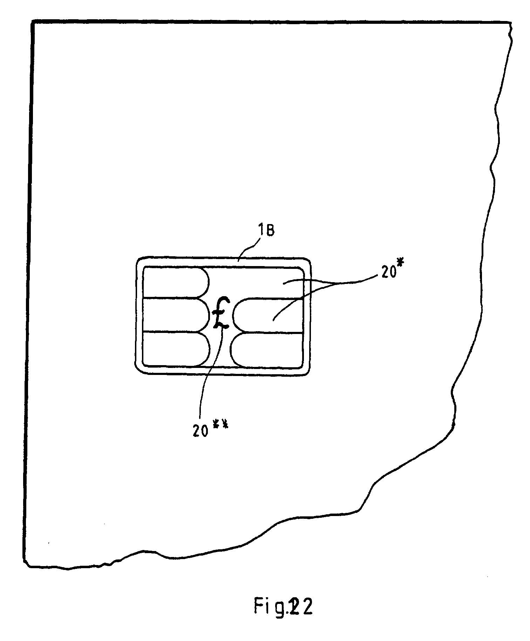

In einer zweiten Ausgestaltungsform (s.Fig. 20,21,22) ist der zweite Flächenbereich (20**) gegenüber dem ersten erhaben. Dabei ist der erhabene, zweite Flächenbereich beispielsweise einmal als ein Firmenlogo (Fig.20) und das andere Mal als ein Währungszeichen (Fig.21) ausgebildet. Hierzu wird in einem ersten Schritt ganzflächig auf die Basismetallisierung (201,202) eine erste Metall- oder Metallegierungsschicht (20*) mit bestimmten Lichtreflexions- und absorptionseigenschaften aufgebracht. In einem zweiten Schritt wird dann auf die erste Metall-oder Metallegierungsschicht (20*) auf einem oder mehreren Teilbereichen eine zweite Metall-oder Metallegierungsschicht (20**) mit von der ersten Metall-oder Metallegierungsschicht verschiedenen Lichtreflexions- und absorptionseigenschaften zur Ausbildung des zweiten Flächenbereichs (20**) galvanisch aufgebracht.

In einer dritten Ausgestaltungsform (nicht dargestellt) ist der erste Flächenbereich (20*) gegenüber dem zweiten Flächenbereich (20**) erhaben. Hierzu wird in einem ersten Schritt ganzflächig auf die Basismetallisierung (201,202) eine erste Metall- oder Metallegierungsschicht mit bestimmten Lichtreflexions- und absorptionseigenschaften aufgebracht. In einem zweiten Schritt wird dann auf die erste Metall- oder Metallegierungschicht ganzflächig eine zweite Metall- oder Metallegierungschicht mit von der ersten Metall-oder Metallegierungsschicht verschiedenen Lichtreflexions- und absorptionseigenschaften zur Ausbildung des zweiten Flächenbereichs (20**) galvanisch aufgebracht. In einem dritten Schritt wird die zweite metall- oder metallegierungsschicht (20**) lokal durch einen elektrochemischen Prozeß (z.B. ein Ätzvorgang) entfernt, so daß die darunter liegende erste Metall- oder Metallegierungsschicht sichtbar wird.

Nachfolgend werden für die farbige Ausgestaltung der sichtbaren Chipmodul-Oberfläche vorteilhafte Ausgestaltungsvarianten beschrieben.

Aus Gründen der Standardisierung ist in der ISO 7816-2 die Lage und Mindestgröße von Normkontaktflächen (20B) vorgegeben, danach dürfen die Normkontaktflächen (20B) eine Größe von 2mm * 1,7mm nicht unterschreiten. Diese Normkontaktflächen (20B) sind in Figur 2 und 4 gestrichelt eingezeichnet. Zur Ausbildung der Kontaktflächen (20A) sind in der Metallisierung (20) isolierende Zwischenräume (Linien,22A) vorgesehen. Erfindungsgemäß wird nun ein farbiges Kunststoff-Substrat (21) verwendet, das durch die isolierenden, lichten Zwischenräume (Linien, 22A) hindurch sichtbar ist (vgl. auch Fig.9). Farbig in diesem Sinne kann auch ein fluoreszierendes Kunststoff-Substrat (21) sein. Für das Kunststoff-Substrat (21) kommen die verschiedensten Materialien in Frage: z.B. Polyvinylchlorid (PVC), Polyethylen, glasfaserverstärktes Epoxydharz o.dgl.

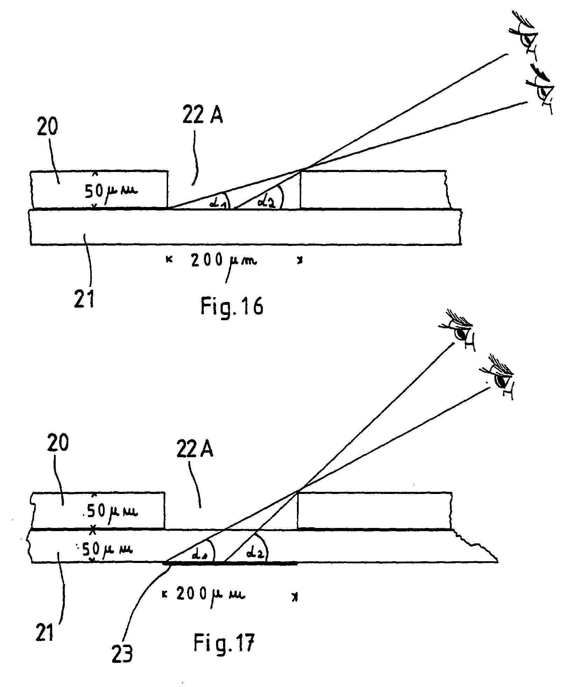

Für einen Betrachter (vgl. Fig. 16), der unter einem Winkel größer als L1 bezogen auf die Kontaktflächen (20A) auf die Karte (1) blickt, ist das farbige Kunstststoff-Substrat (21) aufgrund der Abschattung durch die Metallisierung (20) nicht mehr sichtbar. Bei dem in Figur 16 dargestellten Beispiel (Breite des isolierenden Zwischenraumes: 200µm; Schichtdicke der gesamten Metallisierung: 50µm) beträgt dieser totale Abschattungswinkel 16°, d.h. in einem Blickwinkelbereich von der senkrechten Aufsicht (90°) bis zu einem Blickwinkel von 16° ist das farbige Kunststoff-Substrat (21) zumindest teilweise sichtbar. Der Blickwinkel, bei dem eine Halbabschattung eingetreten ist, ist mit L2 bezeichnet. Bei der in Figur 16 dargestellten Konstellation beträgt dieser Winkel (L₂) 30°. Daran ist deutlich, daß in einem relativ großen Blickwinkelbereich von 60° das farbige Kunststoff-Substrat (21) immer noch bis zur Hälfte sichtbar ist.

Zusätlich zu den isolierenden Zwischenräumen (Linien,22A) können weitere lichte Zwischenräume (22B) vorgesehen sein, durch die hindurch das farbige Kunststoff-Substrat (21) ebenfalls sichtbar ist.

Mit dieser Ausgestaltungssvariante lassen sich die verschiedensten Layout-Gestaltungen realisieren:

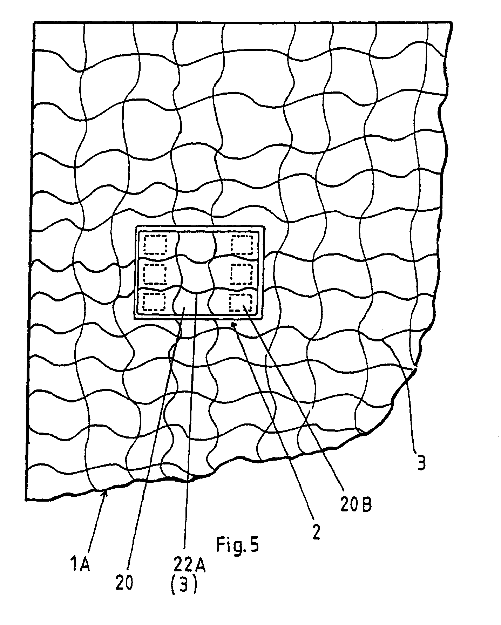

In Figur 5 ist ein Ausschnitt einer Draufsicht auf eine Chipkarte (1) mit einem Guillochenmuster (3) gezeigt. Die das Guillochenmuster (3) bildenden Linien setzen sich auf der die Kontaktflächen (20A) bildenden Metallisierung (20) als isolierende Linien (22A) zwischen den Normkontaktflächen (20B) fort. Wählt man für die auf den Kartenkörper (1A) gedruckten Linien (3) z.B. die Farbe rot, so nimmt man dementsprechend ein rotes Kunststoff-Substrat (21). In Verbindung mit den erfindungsgemäß eingefärbten Kontaktflächen kann dann auf der ganzen Kartenseite, einschließlich Chipmodul-Oberfläche eine einheitlich Farbe hinter dem Guillochenmuster (3) erzielt werden. Die Oberfläche des Chipmoduls (2) ist somit im Kartenlayout integriert und stellt keinen Fremdkörper dar. Darüber hinaus ist hiermit ein erhebliches Maß an zusätzlicher Fälschungssicherheit gegeben, da dieses Chipmodul (2) mit seiner ganz speziell für einen Kartentyp strukturierten und farbig gestalteten Oberfläche, Argwohn erregen würde, wenn es in einen anderen Kartenkörper eingesetzt ist.

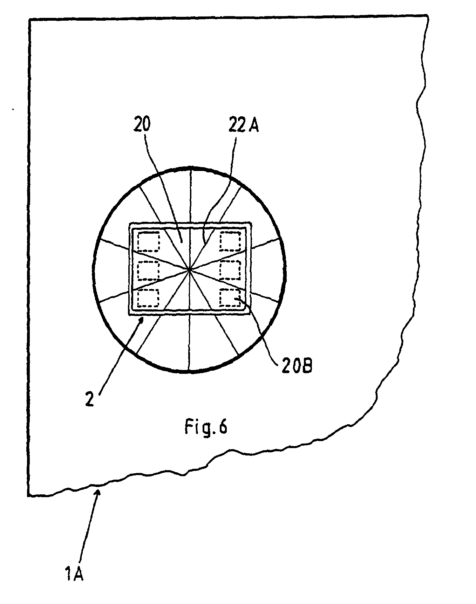

In Figur 6 ist eine weitere Layout-Gestaltung dargestellt. Das Motiv ist ein Rad mit Speichen, wobei die Speichen sich als isolierende Zwischenräume (Linien,22A) zwischen den Normkontaktflächen (1A) fortsetzen. Eine Farbanpassung zwischen den auf dem Kartenkörper (1A) gedruckten Motivanteilen und den Motiv-Anteilen auf der Oberfläche des Chipmoduls (2) ist problemlos möglich.

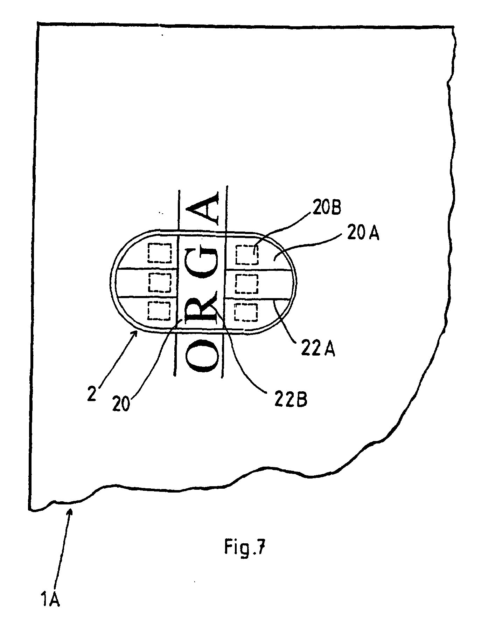

In Figur 7 ist eine weitere Layout-Gestaltung dargestellt. Das Motiv ist hier ein Firmenlogo, wobei jeweils zu beiden Seiten des Chipmoduls (2) ein Buchstabe auf die Kartenvorderseite aufgedruckt ist und die beiden anderen Buchstaben durch zusätzliche Zwischenräume (22B) in der Metallisierung (20) gebildet sind. Durch Wahl eines entsprechend farbigen Kunststoff-Substrats (21) ist auch hier eine Farbanpassung problemlos möglich.

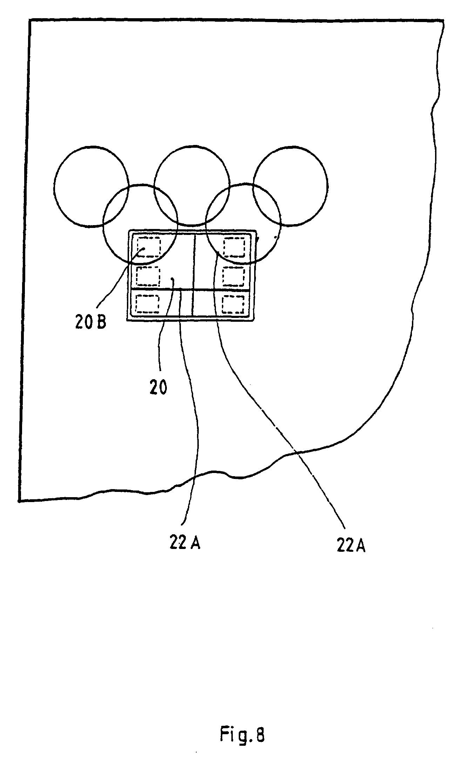

In einer weiteren Ausgestaltungssvariante ist das Kunststoff-Substrat (21) ganz oder teilweise transparent. Auf der der Metallisierung (20) abgewandten Seite (Rückseite) des Kunststoff-Substrats (21) sind dabei ein oder mehrere Farbmuster (23) aufgebracht, so daß die Farbmuster (23) durch das Kunststoff-Substrat (21) und die lichten Zwischenräume (22A, 22B) hindurch sichtbar sind (vgl. Fig. 8,15, 17). In Figur 8 ist eine Layout-Gestaltung dargestellt, die mit dieser Ausgestaltungssvariante technisch realisierbar ist. Als Motiv sind die Olympischen Ringe gewählt, wobei zwei Ringsegmente sich als isolierende Zwischenräume (Linien,22A) auf der Metallisierung (20) fortsetzen. Die auf die Rückseite des Kunststoff-Substrats (21) aufgebrachten Ringsegmente sind verschieden farbig ausgebildet. Korrespondierend zu den weiteren isolierenden Zwischenräumen (Linien, 22A) ist die Rückseite des Kunststoff-Substrats (21) goldfarben bedruckt, was der Farbe der Goldkontaktflächen (20A) entspricht, so daß diese Zwischenräume (Linien,22A) sich von der Metallisierung (20) farblich nicht absetzen. Auf diese Weise läßt sich das Chipmodul (2) im Kartenlayout verbergen. Die Farbmuster (23) können auch auf die Rückseite des Kunststoff-Substrats (21) aufgedruckt oder aufgesputtert werden.

Auch hier läßt sich wiederum ein totaler Abschattungswinkel (α₁ ) und ein Halbabschattungswinkel (α₂) für die sichtbare Wahrnehmung des auf der Rückseite des Kunststoff-Substrats (21) aufgebrachten Farbmusters (23) angeben (vgl. Fig. 17).

Bei dem in Figur 17 dargestellten Beispiel (Breite des isolierenden Zwischenraumes: 200µm; Schichtdicke der Metallisierung: 50µm; Dicke des transparenten Kunststoff-Substrats: 50µm) beträgt der totale Abschattungswinkel (α₁) 60° und der Halbabschattungswinkel (α₂) 50°. Also auch in diesem Fall ist das Farbmotiv durch die isolierenden Zwischenräume (22A) hindurch in einem relativ großen Blickwinkelbereich von 40° noch bis zur Hälfte sichtbar.

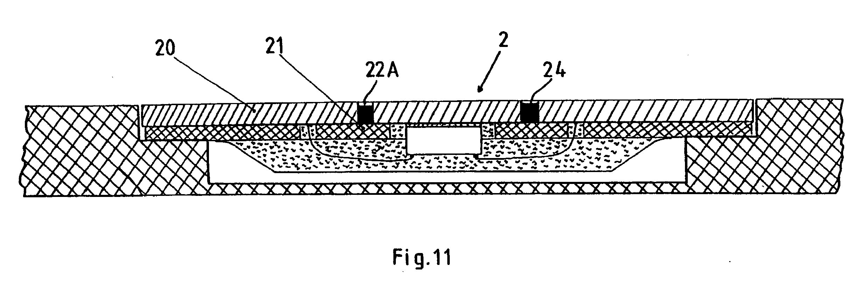

In einer weiteren Ausgestaltungssvariante wird in die isolierenden Zwischenräume (Linien,22A) in der Metallisierung (20) Farbe (24) eingebracht (vgl. Fig.11).

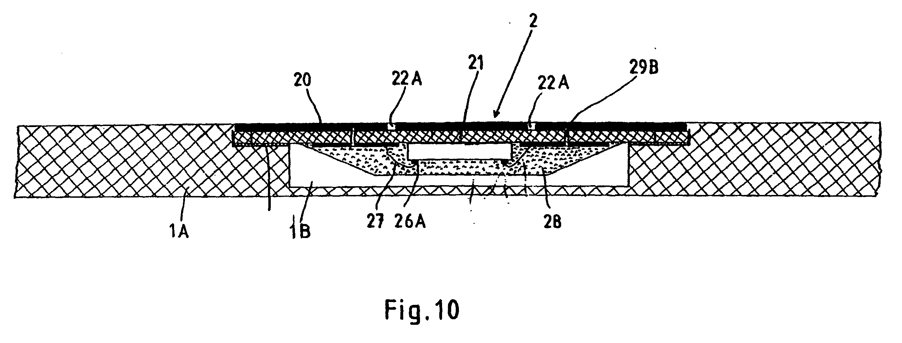

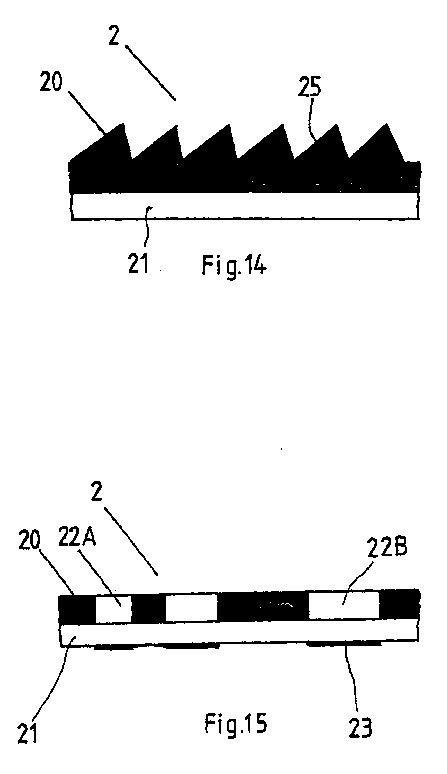

In einer weiteren Ausgestaltungssvariante, die nicht zu der beanspruchten Erfindung gehört, und die hier nur zur Erleichterung des Verständnisses der Erfindung angegeben wird, weist die die Kontaktflächen (20A) bildende Metallisierung (20) zur gezielten Beeinflussung der Lichtreflexion erhabene Strukturen (25) im µm und/oder sub µm Bereich auf, die in die Metallisierung (20) eingeprägt sein können oder durch galvanische Metallabscheidung gebildet sein können. Figur 12 zeigt z.B. ein Firmen-Logo, das als erhabene Struktur (25) auf der Metallisierung (25) vorhanden ist. Figur 13 zeigt einen Schnitt durch die Chipkarte (1) im Bereich dieser erhabenen Struktur (25). Die erhabenen Strukturen (25) können auch als ein Oberflächenrelief ausgebildet sein, welches einem Regenbogenhologramm entspricht. Auch sind z.B. schuppenartige Strukturen möglich, die vielfarbig schillernde Lichtreflexe erzeugen (vgl. Fig. 14). Abschließend sollen die Figuren 9 und 10 zur Verdeutlichung des Aufbaues eines Chipmoduls (2) noch einmal näher erläutert werden:

In Fig. 9 ist ein in einen Kartenkörper (1) implantiertes Chipmodul (2) dargestellt. Das Chipmodul (2) besteht aus den Kontaktflächen (20A), die mit Anschlußpunkten (26A) des IC-Bausteins (26) über Bonddrähte (27) elektrisch leitend verbunden sind. Der IC-Baustein (26) und die Bonddrähte (27) sowie die Anschlußstellen (26A) der Bonddrähte () am IC-Baustein (26) und an den Kontaktflächen (20A) sind zum Schutz vor mechanischen Belastungen, Oxidation und Feuchtigkeit mit einer Vergußmasse (28) umgeben. Der IC-Baustein (26) ist in einer zentralen Aussparung der Kunststoff-Substrats (21) eingesetzt und mit einem Kleber, vorzugsweise einem elektrisch leitfähigen Kleber, auf einer massebezogenen Kontaktfläche (20A) fixiert. Zur Durchführung der Bonddrähte (27) zu den Kontaktflächen (20A) weist das Kunststoff-Substrat (21) Kontaktzugangsöffnungen (29A) auf. Das Chipmodul (2) ist mit einer Heißklebeschicht (4) in einer Aussparung (1B) des Kartenkörpers (1A) fixiert. Auch diese Heißklebeschicht (4) kann erfindungsgemäß eingefärbt sein. In Figur 10 ist der IC-Baustein (26) auf dem Kunststoff-Substrat (21) fixiert. Die Bonddrähte (27) sind mittels Durchkontaktierungen (29B) mit den Kontaktflächen (20A) elektrisch verbunden.

## Patentansprüche

1. Verfahren zur Herstellung von Chipmodulen für Chipkarten, wobei ein zur Herstellung von Chipmodulen(2) dienendes Kunststoffsubstrat, auf dem für eine Vielzahl von Chipmodulen eine Basismetallisierung (201, 202) aufgebracht ist, in ein galvanisches Bad eingebracht wird und die verschiedenen Flächenbereiche (20*, 20**) durch galvanische Abscheidung mit Hilfe selektiver Abdeckung (Passivierung) gebildet werden, wobei in einem ersten Schritt ganzflächig durch galvanische Abscheidung auf die Basismetallisierung (201, 202) eine erste Metall- oder Metalllegierungsschicht mit definierten Lichtreflexions- und Absorptionseigenschaften aufgebracht wird, in einem zweiten Schritt ganzflächig oder nur auf einem Teilbereich auf die erste Metall-oder Metalllegierungsschicht eine zweite Metall- oder Metalllegierungsschicht mit von der ersten verschiedenen Lichtreflexions- und Absorptionseigenschaften galvanisch aufgebracht wird und in einem dritten Schritt die zweite Metall- oder Metalllegierungsschicht lokal durch einen elektrochemischen Prozess entfernt wird, so dass die darunter liegende erste Metall- oder Metalllegierungsschicht sichtbar ist.

2. Verfahren nach Anspruch 1, **dadurch gekennzeichnet, dass** die Basismetallisierung (201, 202) von einer Kupfer- und einer darauf angeordneten Nickelschicht gebildet ist.

## Claims

1. A method for producing chip modules for chip cards, wherein a plastic substrate, which is used to produce chip modules (2) and to which a base plating (201, 202) is applied for a plurality of chip modules, is introduced in a galvanic bath, and the various surface areas (20*, 20**) are formed by means of electrodeposition using selective covering (passivation), wherein in a first step a first metal or metal alloy layer having defined light reflection and absorption properties is applied to the entire surface area of the base plating (201, 202) by means of electrodeposition, in a second step a second metal or metal alloy layer having light reflection and absorption properties that differ from those of the first layer is electrodeposited to the entire surface area or only to a portion of the first metal or metal alloy layer, and in a third step the second metal or metal alloy layer is locally removed using an electrochemical process, whereby the first metal or metal alloy layer located beneath is visible.

2. The method according to claim 1, **characterized in that** the base plating (201, 202) is formed by a copper layer and a nickel layer disposed thereon.

## Revendications

1. Procédé de fabrication de modules de puce pour cartes à puce, dans lequel un substrat de matière plastique servant à la fabrication de modules de puce (2), sur lequel est appliqué une métallisation de base (201, 202) pour une pluralité de modules de puce, est placé dans un bain galvanique et les différentes zones de la surface (20*, 20**) sont formées par dépôt galvanique à l'aide d'un recouvrement sélectif (passivation), dans lequel, dans une première étape, une première couche d'un métal ou d'un alliage métallique offrant des caractéristiques prédéterminées de réflexion lumineuse et d'absorption sur toute la surface par un dépôt galvanique sur la métallisation de base (201, 202), dans une deuxième étape, une deuxième couche de métal ou d'alliage métallique offrant des caractéristiques de réflexion lumineuse et d'absorption différentes de celles de la première, est appliquée galvaniquement sur toute la surface ou seulement sur une partie de la surface de la première couche de métal ou d'alliage métallique et, dans une troisième étape, la deuxième couche de métal ou d'alliage métallique est éliminée localement par un processus électrochimique, si bien que la première couche de métal ou d'alliage métallique sous-jacente est visible.

2. Procédé selon la revendication 1, **caractérisé en ce que** la métallisation de base (201, 202) est formée d'une couche de cuivre et d'une couche de nickel placée au-dessus.
